# EUROPEAN PATENT APPLICATION

(11) **EP 2 560 466 A1**
(43) Date of publication of application: **20.02.2013**
(21) Application number: 11768652.7
(22) Date of filing: 26.01.2011
(51) Int. Cl.: H05K 1/18, H05K 1/14, H05K 3/00

(54) **BOARD AND METHOD FOR MANUFACTURING BOARD**

(30) Priority: 22.11.2010 JP 2010260494; 15.04.2010 JP 2010093672
(71) Applicant: Furukawa Electric Co., Ltd., Chiyoda-ku Tokyo 100-8322 (JP); Furukawa Automotive Systems Inc., Inukami-gun, Shiga 522-0242 (JP)
(72) Inventor: HARA, Toshitaka, Tokyo 100-8322 (JP); HASHIMOTO, Kyosuke, Tokyo 100-8322 (JP); NOJI, Kiyonobu, Tokyo 100-8322 (JP); ABE, Kyutaro, Tokyo 100-8322 (JP); FUKAI, Hiroyuki, Tokyo 100-8322 (JP); TAKAHASHI, Naomi, Tokyo 100-8322 (JP)
(74) Representative: Strehl Schübel-Hopf & Partner
(86) International application number: PCT/JP2011/051412
(87) International publication number: WO 2011/129130

(57) **Abstract**

The board 1 has a transformer 3, choke coil 5 and, for example, is used for a DC-DC converter such as for an automobile. At the board 1, a circuit conductor therein is exposed to outside at an electronic component mounting part 7, a printed board mounting part 11 and a conductor part 10a, and other portions are covered with resin 9 to form an injection molded board 2, which installs an electronic component, etc. The printed board mounting part 11 is a section that is provided for installing a printed board 15. A conductor part 10b of the printed board and the conductor part 10a of the printed board mounting part 11 are joined via an electronic component 16 by soldering, etc.

## Description

### TECHNICAL FIELD

The present invention relates to a board used for a DC-DC convertor, etc. for such as an automobile and a method for manufacturing the same.

A DC-DC converter used for an automobile comprises a plurality of components, such as a transformer for voltage conversion and a choke coil for smoothing. These components are separately manufactured and then connected with each other since high voltage and high current is loaded thereon (Patent document 1).

### PRIOR ART DOCUMENT(S)

### PATENT DOCUMENT(S)

[Patent document 1] Japanese Patent Laid Open No. 2005-143215 A

### SUMMARY OF INVENTION

### TECHNICAL PROBLEM TO BE SOLVED

In such a configuration, however, a device tends to become larger, therefore, a more compact DC-DC converter has been demanded. Alternatively, a method to place the above-mentioned each component on the same board has been known. Usually, such a board that has an electric circuit thereon comprises a layer structure with a plurality of circuits and insulators.

However, a circuit on an ordinary board is formed by plating and etching etc., and thus they cannot resist high current that flows into a DC-DC converter. Hence, in order to resist such high current, it is desirable for conductor layer thickness, for example, to be 0.4 mm or more. However, conductor layer thickness tends to increase in the conventional method, which takes much time to form a conductor layer.

More alternatively, as a board usable under a high current condition, an injection molded board in which a conductor part is formed by pressing and an insulating part is formed by injection molding has been known. Since the conductor part is formed by pressing, for example, such a board is able to resist high current that flows into a DC-DC converter.

At the injection molded board, the insulating part is formed with a mold for injection molding. For this reason, it makes difficult to form a detailed exposed conductor part on the surface of the board. For example, it is necessary to form a detailed exposed conductor part that is to be connected to an electrode of a capacitor in order to install a small electronic component such as a ceramic condenser. However, it is difficult to form such a detailed shape by injection molding because resin might leak out. Additionally, it is also difficult to configure a circuit having a detailed pattern because difficulty rises when processing a detailed shaped conductor by pressing. These problems have remained an obstacle to miniaturize a device.

The present invention has been made in view of such problems. The object of the present invention is to provide a board usable under high current that flows into a DC-DC converter, on which small electronic components can be placed, and a method for manufacturing the same.

### SOLUTION TO PROBLEM

In order to achieve the above object, the first aspect of the present invention provides a board comprising: an injection molded board that is molded by injection of resin toward a surface of a circuit conductor; a first electronic component that is electrically joined on the injection molded board; a printed board that installs a second electronic component thereon; wherein a printed board mounting part that is formed on the injection molded board; and wherein the printed board is electrically connected to the injection molded board at the printed board mounting part.

In a condition where the printed board is installed on the printed board mounting part, a printed board side conductor part being exposed on a top surface of the printed board and an injection molded board side conductor part being exposed on a top surface of the injection molded board may be electrically joined via the first electronic component.

A concave part for applying solder may be formed on the injection molded board side conductor part. In this case, it is more desirable for a size of the concave part to be not narrower than that of the printed board side conductor part that is to be a subject to connection.

The printed board mounting part may install the printed board, with a gap around the printed board; and a positioning member that is used to determine a position of the printed board may be provided on the printed board mounting part.

When the printed board is approximately rectangle and the first electronic components that connect the printed board and the injection molded board are placed on opposite lines of the printed board, each of the first electronic components on opposite lines may be placed off alignment with each other.

A reinforcing board may be provided at inside of the injection molded board so as to stride over the printed board mounting part.

An electronic component mounting part may be provided on the injection molded board, and a third electronic component may be electrically joined with the circuit conductor being exposed at the electronic component mounting part, and the circuit conductor being exposed at the printed board mounting part is electrically joined with the printed board.

A stress releasing part may be formed in the printed board so as to penetrate the printed board.

A plurality of electronic components is provided on a surface of the printed board, and an electrode part that is to be joined with the circuit conductor exposed at the printed board mounting part is exposed at a back side of the printed board and the stress releasing parts may be arranged side by side, between each of the electronic components to be installed on the printed board and between the electrode parts as well, in a plurality of rows and at a plurality of positions within the respective rows. Additionally, an electronic component is provided in an approximately center of the printed board and the stress releasing part may be radially formed from the electronic component.

Other than an electrode part that is electrically connected to the circuit conductor, a holding part that is provided for holding the printed board to the printed board mounting part may be formed at a back side of the printed board and the holding part is held by solder to the printed board mounting part.

Thickness of the circuit conductor of the injection molded board may be not less than 400 micrometers and thickness of a conductor in a circuit part of the printed board may be not more than 125 micrometers.

Resin for injection molded board is selected from one of a liquid crystal polymer, poly phenylene sulfide, polybutylene terephthalate, poly ether sulphone, polyether ether ketone, poly phthalamide and the printed board may be configured with glass epoxy.

According to the first aspect of the present invention, since the injection molded board comprises a circuit conductor formed by pressing and resin formed by injection molding, it is able to provide a thick circuit conductor, which can be usable under high current condition. Additionally, the injection molded board comprises a printed board mounting part for installing a printed board. Also, the injection molded board comprises a printed board mounting part for installing a printed board. Accordingly, since a small electronic component is installed on the printed board by the conventional means but a large-sized electronic component and a printed board itself can be installed on the injection molded board, it is unnecessary to form a detailed conductor exposing part, etc. by injection molding.

Furthermore, according to the first aspect of the present invention, the printed board and the injection molded board are joined on the top surface of the board via an electronic component. Accordingly, it is unnecessary to connect an electronic component and the printed board by a wire, a connector, etc. by separately installing other electronic component on the side of the injection molded board, which makes it possible to manufacture a more compact board. Also, it is able to view a connecting area of the printed board and the injection molded board since the connecting area is provided on the top surface of the board.

Furthermore, according to the first aspect of the present invention, a concave part that is provided for applying solder on the conductor part as a connecting area on the side of the injection molded board is formed. The concavo part prevents solder from flowing out to the conductor exposing part on the injection molded board, which is relatively larger in size when soldering in a reflow furnace etc. In this process, if the concave part is provided to be larger than the size of the conductor part on the side of the printed board, it is able to prevent defect in soldering that might be occurred by a positional gap between the printed board and the injection molded board.

Furthermore, according to the first aspect of the present invention, since a positioning member for determining the position of the printed board such as a guide, a pin, etc. is provided on the printed board mounting part, it is able to install the printed board on the injection molded board at the exact position.

Furthermore, according to the first aspect of the present invention, when connecting the printed board and the injection molded board, since the opposite lines of the printed board are connected off alignment, it is able to distribute the stress generated in association with difference in linear expansion. Accordingly, ut makes possible to decrease the stress to the connecting area of the printed board and the injection molded board, which is occurred in association with the temperature change, and also is able to prevent breakage of solder, etc.

Furthermore, according to the first aspect of the present invention, since a reinforcing board that is buried at the injection molded board is provided at the lower part of the printed board mounting part as to stride over the longitudinal direction of the printed board mounting part, it is able to prevent the deformation of the printed board mounting part, such as warping, etc.

Furthermore, according to the first aspect of the present invention, since a stress releasing part is provided on the printed board, it is able to ease the stress that might be generated by difference in a coefficient of linear expansion of the materials for the injection molded board and the printed board in association with the temperature change.

Furthermore, according to the first aspect of the present invention, since the stress releasing parts are arranged in zigzag when the printed board installs a plurality of electronic components thereon, it is able to maintain the strength of the printed board per se and to efficiently obtain the stress releasing effect.

Furthermore, according to the first aspect of the present invention, since the printed board and the injection molded board are connected not only electrically but also with a connecting area for holding, it is able to hold the printed board on the injection molded board more firmly.

Furthermore, according to the first aspect of the present invention, when the circuit conductor of the injection molded board is not less than 400 micrometers, the board is able to certainly resist high current. Additionally, when the circuit conductor of the printed board is not more than 125 micrometers, it is able to manufacture a more compact board. Moreover, when resin for the injection molded board is selected from one of the selected from one of a liquid crystal polymer, poly phenylene sulfide, polybutylene terephthalate, poly ether sulphone, polyether ether ketone, poly phthalamide, it is able to increase the injection-molding processability. Furthermore, as a printed board, it is sufficient to employ a glass epoxy board but does not require any special one.

The second aspect of the present invention provides a method for manufacturing a board comprising the steps of: joining circuit materials that are conductors to form a circuit conductor; injecting molding resin toward a surface of the circuit conductor to mold an injection molded board of which a surface includes an electronic component mounting part and a printed board mounting part; and connecting electrically an electronic component to the circuit conductor being exposed at the electronic component mounting part and also connecting electrically a printed board that has installed an electronic component beforehand to the circuit conductor being exposed at the printed board mounting part.

A method for manufacturing a board may also comprise the steps of: joining circuit materials that are conductors to form a circuit conductor; injecting molding resin toward a surface of the circuit conductor to mold an injection molded board of which a surface has a printed board mounting part; placing a printed board on the printed board mounting part; placing solder and a first electronic component respectively on a printed board side conductor part that is exposed on a top surface of the printed board and on an injection molded board side conductor part that is exposed on a top surface of the injection molded board; and soldering the first electronic component with the printed board side conductor part and the injection molded board side conductor part at one time in a reflow furnace to join the printed board with the injection molded board via the first electronic component. In this case, a plurality of second electronic components and solder may be placed on the printed board to join the second electronic component on the printed board simultaneously with soldering the second electronic component.

According to the second aspect of the present invention, it is able to provide a method for manufacturing a board usable under high current condition, which is easily manufactured and on which even small electronic components can be placed certainly.

### ADVANTAGEOUS EFFECTS OF INVENTION

According to the present invention, it is able to provide a board usable under high current that flows into a DC-DC converter, and on which small electronic components can be placed, and a method for manufacturing the same.

### BRIEF DESCRIPTION OF THE DRAWINGS

[Fig. 1] Fig. 1 illustrates a board 1, particularly Fig. 1 (a) is an exploded perspective view and Fig. 1 (b) is an assembly perspective view.
[Fig. 2] Fig. 2 is a top view of a board 1.
[Fig. 3] Fig. 3 is a sectional view of a printed board mounting part 11, particularly, is an E-E line sectional view of the F-section in Fig. 2.
[Fig. 4] Fig. 4 illustrates an example of a circuit on a board.
[Fig. 5] Fig. 5 is an enlarged view of a conductor parts 10a and 10b, particularly,
Fig. 5 (a) is enlarged view of the G-section in Fig. 3, and Fig. 5 (b) is a transparent top view seeing through an electronic component 16, etc.
[Fig. 6] Fig. 6 illustrates the positioning structure of a printed board, particularly,
Fig. 6 (a) is a top view of a printed board 15, Fig. 6 (b) is an enlarged view of a positioning pin 42 at the H-H line sectional surface in Fig. 6 (a), and Fig. 6 (c) illustrates a positioning guide 44.
[Fig. 7] Fig. 7 illustrates a positional relationship between electronic components at a printed board 15.
[Fig. 8] Fig. 8 illustrates a board 40, particularly, Fig. 8 (a) is an exploded perspective view and Fig. 8 (b) is an assembly perspective view.
[Fig. 9] Fig. 9 is a top view of a printed board 40.
[Fig. 10] Fig. 10 is a top view of a printed board 46.
[Fig. 11] Fig. 11 illustrates a printed board 46a.
[Fig. 12] Fig. 12 illustrates a board 1a, particularly, Fig. 12 (a) is an exploded perspective view and Fig. 12 (b) is an assembly perspective view.
[Fig. 13] Fig. 13 is a top view of a board 1a.
[Fig. 14] Fig. 14 illustrates a printed board 15, particularly, Fig. 14 (a) is a front side perspective view and Fig. (b) is a back side perspective view.
[Fig. 15] Fig. 15 illustrates modifications of a printed board, particularly, Fig. 15 (a) illustrates a printed board 15a, Fig. 15 (b) illustrates a printed board 15b, and
Fig. 15 (c) illustrates a printed board 15c.
[Fig. 16] Fig. 16 illustrates a board 30, particularly, Fig. 16 (a) is an exploded perspective view and Fig. 16 (b) is an assembly perspective view.
[Fig. 17] Fig. 17 illustrates a pattern 38 at a printed board 30.
[Fig. 18] Fig. 18 illustrates a printed board 31, particularly, Fig. 18 (a) is a top view and Fig. 18 (b) is a back side view.
[Fig. 19] Fig. 19 illustrates modifications of a printed board, particularly, Fig. 19 (a) is a top view of a printed board 31 a, and Fig. 19 (b) is a back side view of the same.
[Fig. 20] Fig. 20 illustrates a pattern 38a at a printed board 30a.

### DETAILED DESCRIPTION OF EMBODIMENTS

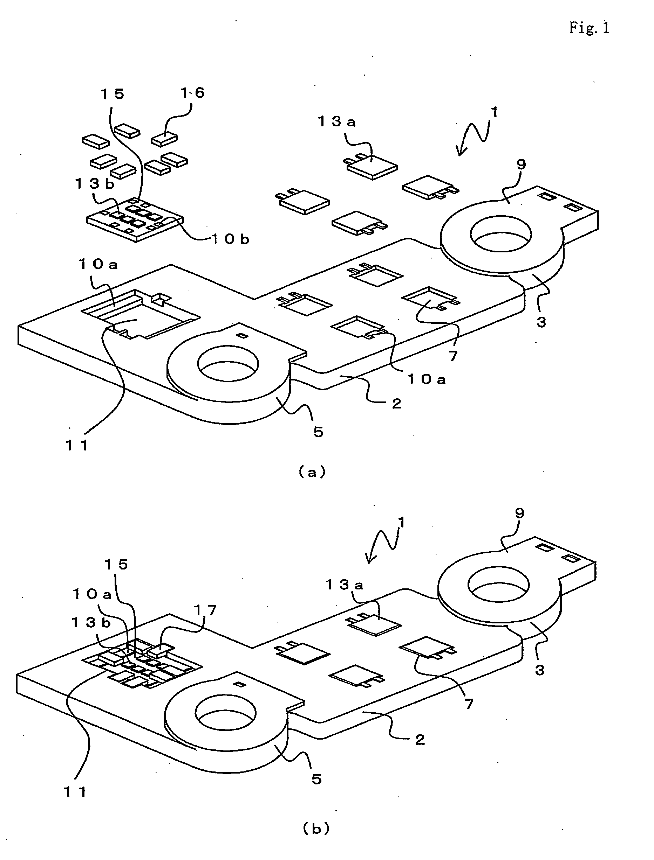

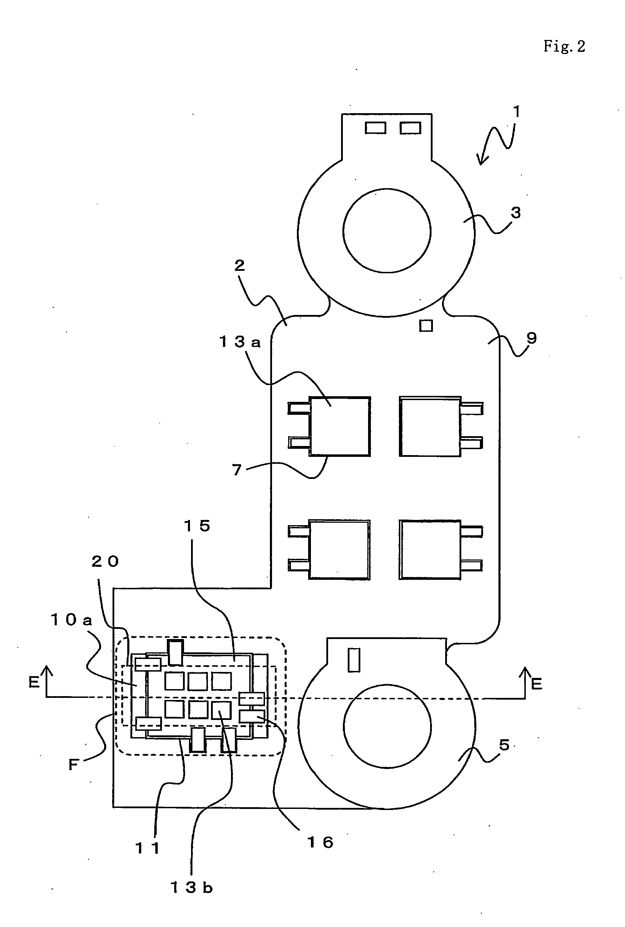

Hereinafter, embodiments of the present invention will be described with reference to the accompanying drawings. Fig. 1 and Fig. 2 illustrate a board 1. Fig. 1 (a) is an exploded perspective view, Fig. 1 (b) is an assembly perspective view, and Fig. 2 is a top view. Figs 1 and 2 omit to illustrate such as soldering part therein. The board 1 has a transformer 3, choke coil 5, etc. and, for example, is used for a DC-DC converter for an automobile. At the board 1, an electronic component mounting part 7 and a printed board mounting part 11 are formed such that a circuit conductor therein is to be exposed to outside at a conductor part 10a and other portions are covered with resin 9 to form an injection molded board 2. The injection molded board 2 installs an electronic component etc. thereon.

A transformer 3 provided at the board 1 (the injection molded board 2) is a coil for voltage conversion. The transformer 3 lowers the pressure of the current inputted from outside, rectifies the alternating current of which the pressure was lowered, by an electronic component 13a (a diode), and smoothes the rectified current by a smoothing circuit which is configured with the choke coil 5 and a capacitor that is not illustrated herein, to output it to outside. The electronic component mounting part 7 is a section that is provided for installing such as an electronic component thereon. The electronic component 13a is electrically connected to the board 1, for example, by the conductor part 10a. The printed board mounting part 11 is a section that is provided for installing a printed board. The printed board 15 is electrically connected to the conductor part 10a of the injection molded board 2 by a conductor part 10b.

A board according to the present invention is not restricted to use for a DC-DC converter having the transformer 3 and the choke coil 5 as illustrated in the drawings, but the present invention is applicable to any boards into which high current flows. Hence, the formations and shapes of a board are not restricted to the ones illustrated in the drawings, but other components etc. may be arranged thereon suitably, or other formations and shapes may be employed suitably.

The printed board 15 installs a plurality of electronic components 13b that are the second electronic components. The conductor part 10b is exposed on the surface of the printed board 15. The conductor part 10b is a section that is provided to be connected to an electronic component 16 as a first electronic component, which will be described later. There is a case where a plurality of small capacitors is installed between a power supply and a ground (GND) when it is necessary to smooth the current at a power circuit from which outputs high current. Since electrodes of the small capacitors which constitute such a circuit are small, it is difficult to form a detailed connecting area (a circuit conductor exposed part) by the above mentioned injection molding.

For the reason outlined above, such a circuit is configured by using a conventional glass epoxy board. A glass epoxy board is formed by electrolytic copper foil that is formed in layers and by a through hole for an interlayer connection, which is plated. Generally, electrolytic copper foil of not more than105 micrometers in thickness is used for a conductor part of such a printed board made of glass epoxy. When a through hole plating of 20 micrometer in thickness is filled, the circuit conductor becomes not more than125 micrometer in thickness.

In this way, the printed board 15 includes small ceramic condensers as a plurality of electronic components 13b installed on the glass epoxy board. The ceramic condensers are electrically connected to the printed board 15.

The printed board 15 is joined with the conductor part 10a of the printed board mounting part 11 via the electronic component 16 by soldering, etc. In this way, the printed board 15 functions as a circuit on the board 1. At the board 1 formed with the printed board 15, low current for such as a signal uses a circuit on the printed board 15 (small condensers, etc.), and high current for power may use a circuit conductor on the injection molded board. All these circuits can be installed on one board and it becomes unnecessary to connect each board by a cable, etc., which enables to manufacture a more compact board at low cost.

The electronic components 13b are joined with the printed board 15 in the process of printing creamy solder at predetermined positions, installing the components such as small condensers at predetermined positions, and melting the solder by passing through a reflow furnace.

A reinforcing board 20 is buried at the injection molded board 2 at the bottom of the printed board mounting part 11. The reinforcing board 20 is formed so as to stride over the entire part of the printed board mounting part 11 against the longitudinal direction of the printed board 15 (the printed board mounting part 11). The printed board mounting part 11, which is concave portion for mounting the printed board 15, has lower strength than the other portions. For this reason, deformation of the printed board mounting part 11, such as warping, might be occurred by change of temperature or mechanical stress. The reinforcing board 20 is provided for preventing such deformation. As the reinforcing board 20, resin, metal, etc. that is harder than resin 9 can be used. Also, the reinforcing board 20 may be provided so as to cover the entire part of the printed board mounting part 11.

The board 1 is manufactured as follows. Firstly, circuit materials that are conductors for a copper plate, etc. are cut off by pressing, and they are bended to be formed in desired shape. Sn plating etc. may be applied to a copper plate if appropriate. Secondly, a plurality of circuit materials are welded with each other or joined via an insulating member with each other to form a circuit conductor. The circuit conductor may be formed not only in the plane but also can be formed in layers with a plurality of layers.

After the circuit conductor obtained in the above-mentioned process is fixed at the predetermined position of the injection molding mold by pins, etc., resin is injected toward the circuit conductor for molding. In this process, a portion other than an exposed part is covered with resin, and also, resin 9 is injected between layers of each of the circuit materials. In this way, the injection molded board 2 is formed.

As resin 9, the ones which are insulating and capable of being injected for molding are good for use, for example, a liquid crystal polymer, poly phenylene sulfide, polybutylene terephthalate, poly ether sulphone, polyether ether ketone, poly phthalamide, etc. can be used.

As the circuit materials, for example, a copper plate being not less than 400µm thick is used. This is because when it is less than 400µm thick, it cannot resist high current, and moreover, it might be deformed by pressure of resin caused at the time of injection molding. It is more desirable for thickness of a conductor circuit material to be 400µm to 1000µm. This is because when it is too thick, cost and weight increases, which causes difficulty to manufacture a more compact board.

Next, the electronic component 13a is installed on the electronic component mounting part 7. Also, at the same time, the printed board 15 is installed on the printed board mounting part 11. In order to join the electronic component 13a with the conductor part 10a of the electronic component mounting part 7, solder, etc. can be used. Solder can be also used for junction of the electronic component 16 and the conductor parts 10a and 10b of the printed board mounting part. Hence, creamy solder in paste form is arranged at connecting areas of each of the electronic components beforehand so that the electronic components can be connected at one time by heating the entire body in a reflow furnace etc.

The electronic components 13b on the printed board 15 can also be joined by solder simultaneously with junction of the electronic components 13a and 16, etc. In this case, solder cream and the electronic components13b are arranged at the connecting areas for electronic components 13b on the printed board 15 beforehand so that the electronic components 13a, 13b and 16 can be connected to the respectively connecting areas at one time by heating the entire body in a reflow furnace.

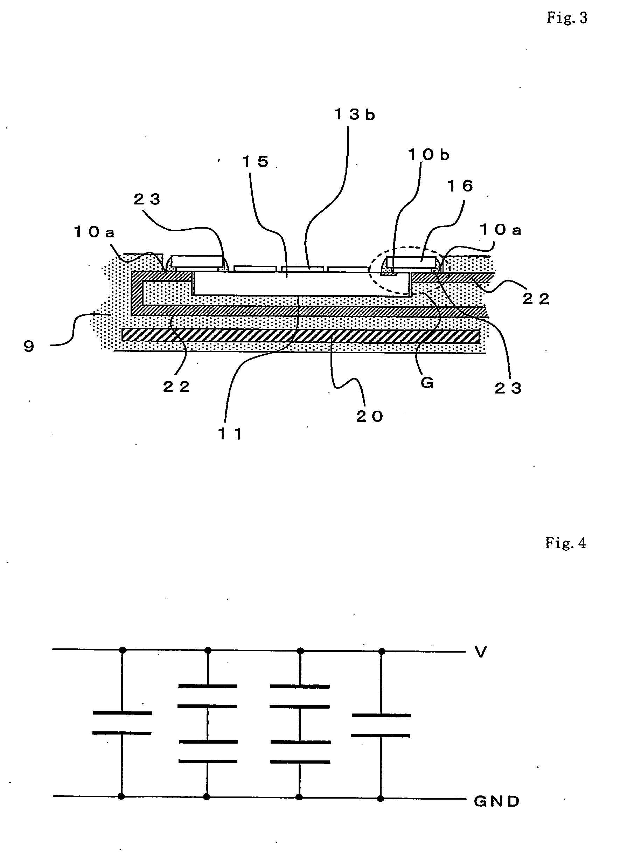

Next, the connecting structure of the printed board 15 and the injection molded board 2 at the printed board mounting part 11 will be described in detail hereinafter. Fig. 3 is an E-E line sectional view of the F section in Fig. 2. The printed board mounting part 11 is a concave part formed on the surface side so that the printed board 15 can be installed thereon and its size is slightly larger than that of the printed board 15. The conductor 10a is formed in strip-shaped or partially, at least at one of the sides of the printed board mounting part 11 so as to expose a circuit conductor 22 of the inside of the injection molded board 2. In this way, the conductor part 10a is exposed on the top surface of the board 1.

On the other hand, at the top surface of the printed board 15, the conductor part 10b having electrical continuity with a circuit inside is placed suitably. When the printed board mounting part 11 installs the printed board 15 thereon, the top surface of the printed board 15 (the conductor part 10b) and the top surface of the conductor part10a at the printed board mounting part 11 can be seen as they are on the same plane.

The printed board 15 and the injection molded board 2 are connected via the electronic component 16. One of the conductor parts of the electronic component 16 is placed on the conductor part 10b on the printed board 15, and the other conductor part is placed on the conductor part 10a of the printed board mounting part 11 (the injection molded board 2). In this condition, each of the conductors is connected electrically by solder 23. Accordingly, a circuit of the printed board 15 is connected to the circuit on the side of the injection molded board 2 via the electronic component 16, as well as the printed board 15 is fixed to the injection molded printed board 2.

Next, the printed board 15 will be described. For example, there is a case where a plurality of small capacitors is installed between a power supply and a ground (GND) when it is necessary to smooth the current at a power circuit from which outputs high current. For example, a circuit in Fig. 4 illustrates such a case. Since electrodes of the small capacitors which constitute such a circuit are small, it is difficult to form a detailed connecting area (a circuit conductor exposing part) by the above mentioned injection molding.

For the reason outlined above, such a circuit is configured by using a conventional glass epoxy board. A glass epoxy board includes an electrolytic copper foil that is formed in layers and a plated through hole for an interlayer connection. Generally, electrolytic copper foil of not more than 105 micrometers in thickness is used for a conductor part of such a printed board made of glass epoxy. When a through hole plating of 20 micrometer in thickness is filled, the circuit conductor becomes not more than 125 micrometer in thickness as a whole.

The conductor part 10a of the printed board mounting part 11 is provided in the position where is stepped lower than the top surface of the injection molded board 2 such that the electronic component 16 is not protruded from the top surface of the injection molded board 2. This is one of the examples of the present invention, therefore, a conductor part according to the present invention is not restricted to this example, but the conductor part 10a may be provided so as to be on the same plane as the top surface of the injection molded board 2.

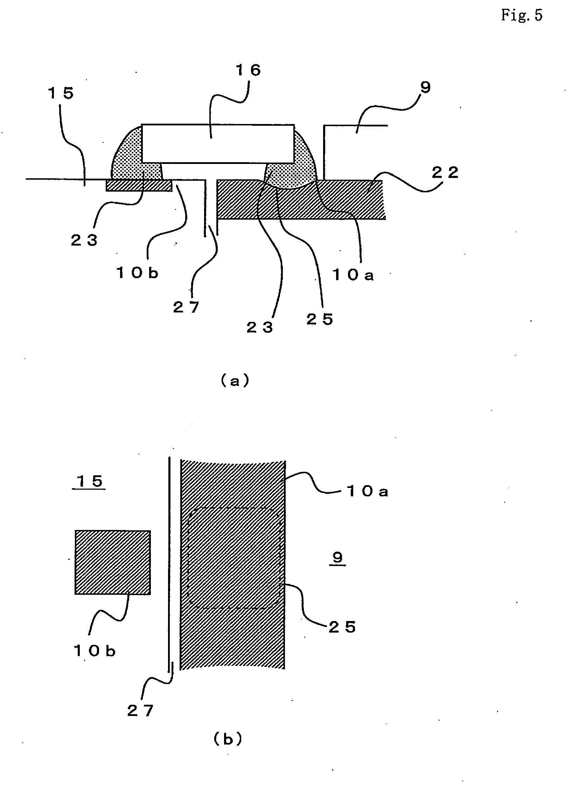

Fig. 5 (a) is an enlarged view of the G section in Fig. 3 and illustrates a portion near solder 23 that is used for junction of the electronic component 16 and the conductor parts 10a and 10b. Fig. 5(b) is a transparent top view of the conductor parts 10a and 10b, in which the electronic component 16 and solder 23 are seen through.

Since the conductor part 10b formed on the printed board 15 can be formed by printing (etching) as a general glass epoxy board is formed, it is able to form an accurate and detailed shaped conductor. On the other hand, since the conductor part 10a is formed by injection molding, it is difficult to form it into a detailed shape, and in addition to this, the conductor part 10a tends to need larger area than the conductor part 10b. This might allow solder 23 that is used for connecting the conductor and the electronic component 16 to flow into an area other than a connecting area.

In order to prevent solder 23 from flowing out, a concave part 25 is provided at the conductor part 10a according to the present invention. The connecting area of the conductor part 10a and the electronic component 16 includes a concave part 25 beforehand. The range (size) of the concave part 25 is determined such that its range (size) is not narrower (smaller) than that of the conductor part 10b that serves a subject to junction. In this way, even if the printed board 15 is slightly off alignment when being installed and a position gap happens to be occurred within the printed board mounting part 11, the concavo part 25 can absorb this positional gap.

As illustrated in Fig. 5 (b), the printed board 15 includes a small gap 27 therearound in the condition where the printed board mounting part 11 installs the printed board 15 thereon. The gap 27 is formed to prevent that the excessive force is applied to the printed board, etc. by such as deformation occurred by thermal expansion difference between the printed board 15 and the injection molded board 2 (resin 9).

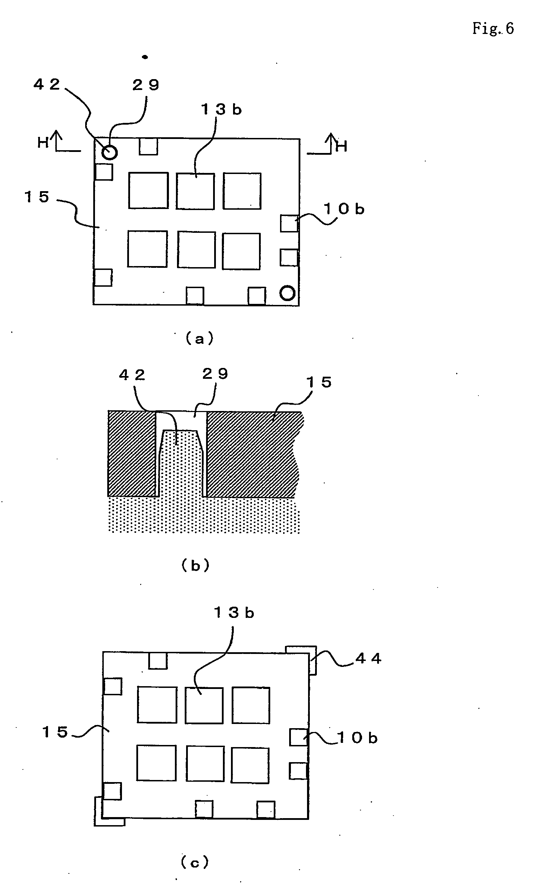

On the printed board mounting part 11, a positioning member may be provided. Fig. 6 (a) is a top view, and Fig. 6 (b) is a sectional view of the H-H line of Fig. 6 (a), illustrating an area near a positioning pin 42. As the positioning member, for example as illustrated in Fig. 6 (a), a hole 29 may be provided on a part of the printed board 15 (for example, a pair of the ones provided on a diagonal line), and the positioning pin 42 corresponding to the holes may be provided on the printed board mounting part 11.

The positioning pin 42 is formed, at the predetermined position of the printed board mounting part 11, to be one body by resin 9. The printed board 15 including the hole 29 of which inside diameter is slightly bigger than outside diameter of the positioning pin 42 is installed on the printed board mounting part 11. In this way, the printed board 15 is installed on the printed board mounting part 11 at the exact position.

As the positioning member, it is not restricted to the positioning pin 42, but positioning guides 44 may be formed as illustrated in Fig. 6 (c). The positioning guides 44 are formed, as at least a pair on a diagonal line of the printed board 15 so as to correspond the outside of the corners of the printed board 15. Since the positioning guides 44 regulate the position of the periphery of the printed board 15, the printed board 15 can be installed on the printed board mounting part 11 at the exact position.

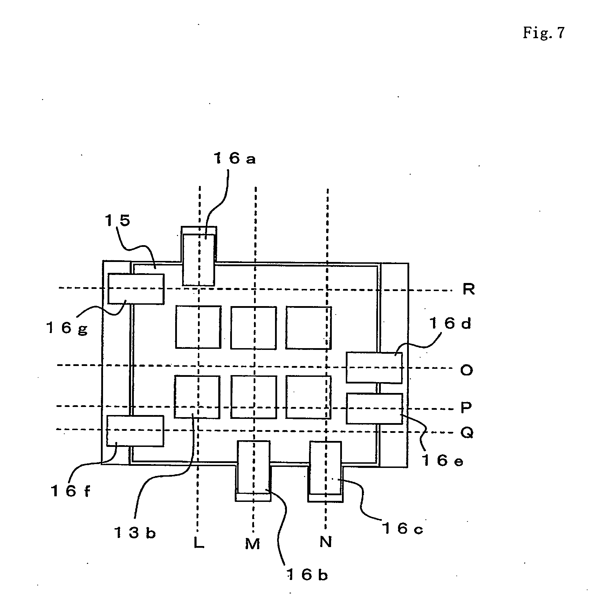

Next, the arrangement of the electronic components 16 that connect the printed board 15 with the injection molded board 2 will be described hereinafter. Fig. 7 illustrates the arrangement of the electronic components on the printed board 15. As described above, the electronic components 16 are installed so as to stride over the printed board 15 (the conductor part 10b) and the injection molded board 2 (the conductor part 10a) to be joined respectively.

Fig. 7 illustrates an example in which the electronic components 16a to 16g are placed on each of the lines of the approximately rectangle printed board 15. Suppose that the electronic component 16a is placed on one of the lines (for example, the line on the upper side of the drawing), and the electronic components 16b and 16c are formed on the opposite line to the line above (for example, the lines on the lower side of the drawing). In this case, the positions of the electronic components 16a, 16b and 16c on each of the relevant lines of the printed board 15 (the center lines perpendicular to the relevant lines with each of the electronic components) are illustrated in the drawings as L, M and N respectively. Each of the positions L, M and N for the electronic components 16a, 16b and 16c are off alignment and not overlapped with each other.

Similarly, suppose that the electronic components 16d and 16e are placed at one of the lines (for example, the line on the right side of the drawing), and the electronic components 16f and 16g are formed on the opposite line to the line above (for example, the lines on the left side of the drawing). In this case, the positions of the electronic components 16d, 16e, 16f and 16g on each of the relevant lines of the printed board 15 (the center lines perpendicular to the relevant lines with each of the electronic components) are illustrated as O, P, Q and R respectively. Each of the positions O, P, Q and R for the electronic components 16d, 16e, 16f and 16g are off alignment and not overlapped with each other.

In this way, the electronic components 16 that connect the printed board 15 and the injection molded board 2 are placed off alignment against the opposite lines with each other. For this reason, the printed board 15 is not restrained at the both ends on arbitrary straight lines parallel to each of the lines even when the deformation etc. is occurred in association with the difference in the thermal expansion coefficient between the printed board 15 and the injection molded board 2. Therefore, it can prevent that the excessive stress is forced to the connecting areas (solder parts) of each of the electronic component 16.

As described above, according to the present invention, it is able to obtain the board 1 usable under high current condition and having high manufacturability since the circuit materials are formed by pressing to form a thick copper board and further, resin 9 is used for injection molding.

Furthermore, the conductor part 10b of the printed board 15 and the conductor part 10a of the injection molded board 2 are formed on the top surfaces of each board, and they are connected with each other via the electronic component 16. Accordingly, each board is connected directly, which makes it possible to manufacture a more compact board.

Furthermore, since the electronic component 16 is joined on the upper surfaces of the injection molded board and the printed board, the connecting areas can be viewed. Also, the electronic components 13a, 13b and 16 can be soldered at one time. Accordingly, it is easy to solder them.

Furthermore, since the concave part 25 is formed at the conductor part 10a on the injection molded board 2, solder 23 is not flowed out and consequently solder 23 can be mounted certainly on the connecting area for the electronic component. In this process, if the concave part 25 is provided to be not narrower than the size of the conductor part 10b of the printed board 15, a gap of the connecting position, which has been occurred in the connecting position at the time of connecting the printed board 15 and the electronic component 16, can be absorbed.

Furthermore, since the positioning member for the printed board 15 is provided on the printed board mounting part 11, it is able to install the printed board 15 on the exact position of the printed board mounting part 11.

Furthermore, since the electronic components 16 that are on the opposite lines of the printed board 15 are placed on the positions that are off alignment, both points that the peripheral part of the printed board intersects with arbitrary lines parallel to each line of the printed board 15 are not restrained by the electronic components 16. Therefore, stress forcing solder 23 for connecting the electronic component 16, that would be occurred in association with the thermal expansion (heat contraction) generated by change of temperature, can be eased

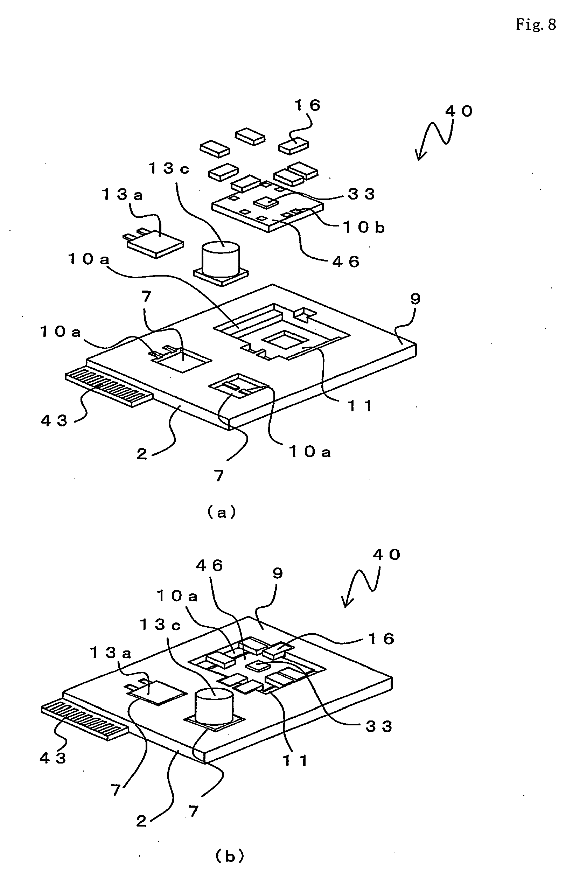

Next, the second embodiment will be described hereinafter. Fig. 8 is a view of a board 40 according to the second embodiment, particularly, Fig. 8 (a) is an exploded perspective view and Fig. 8 (b) is an assembly perspective view. In the following explanation, the same numerals as the ones used in Fig. 1 etc. are allotted to structural elements having similar functions as those of the board 1, and the explanations overlapping with each other will be omitted.

A board 40 has approximately the same structure as the board 1, however, it has different mode of a printed board 46 and an injection molded board 2 from those of the board 1. The board 40 comprises an electronic component mounting part 7 installing large-sized electronic components 13a and 13c, such as a diode and an electrolytic condenser, thereon, and they are electrically connected with each other. A printed board mounting part 11 installs the printed board 46 thereon.

On the printed board mounting part 11, a conductor part 10a, as an exposed conductor part, is formed. The conductor part 10a is a portion for which is provided to be electrically connected to a circuit of the board 40, and for which is provided to be electrically connected via an electronic component 16 by solder, etc., to a conductor part 10b that is arranged on the top surface of the printed board 46.

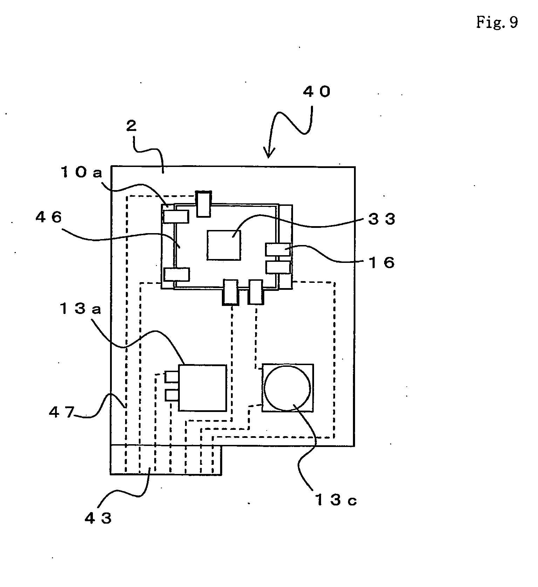

The board 40 is electrically connected to an external component, a power supply, or other member via a connector 43. Fig. 9 schematically illustrates a pattern formed with a circuit conductor in the inner side of the board 40. At the inside of the board 40, as illustrated in Fig. 9, the electronic components 13a and 13c, the printed board 46 and the connector 43, etc. are electrically connected with each other by a pattern 47.

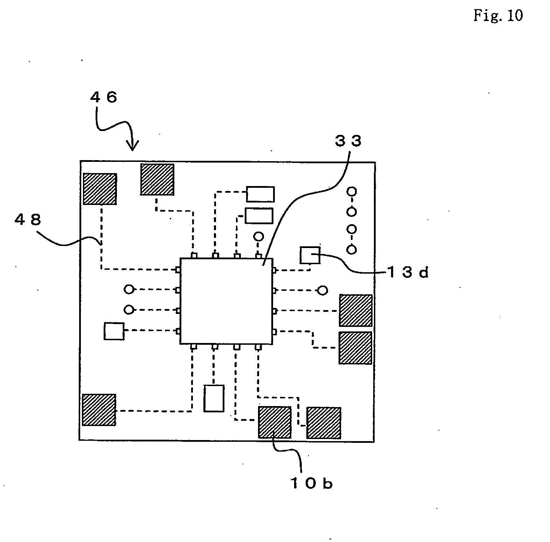

Fig. 10 is a top view illustrating the printed board 46. The printed board 46 includes a CPU 33 (a Central Processing Unit) that is an electronic component at the approximately center thereof. The printed board 46 also has a pattern 48 that is a circuit to be connected with the CPU 33. The CPU 33 is connected to each of the conductor parts10b or other electronic component 13d, etc. by the pattern 48. An electronic component may be installed at the back side of the printed board 46 beforehand, and a GND terminal, etc. also can be provided thereon.

The printed board 46 is installed on the printed board mounting part 11 of the injection molded board 2, and each of the conductor parts 10b are electrically connected to the corresponding conductor parts 10a via electronic components 16.

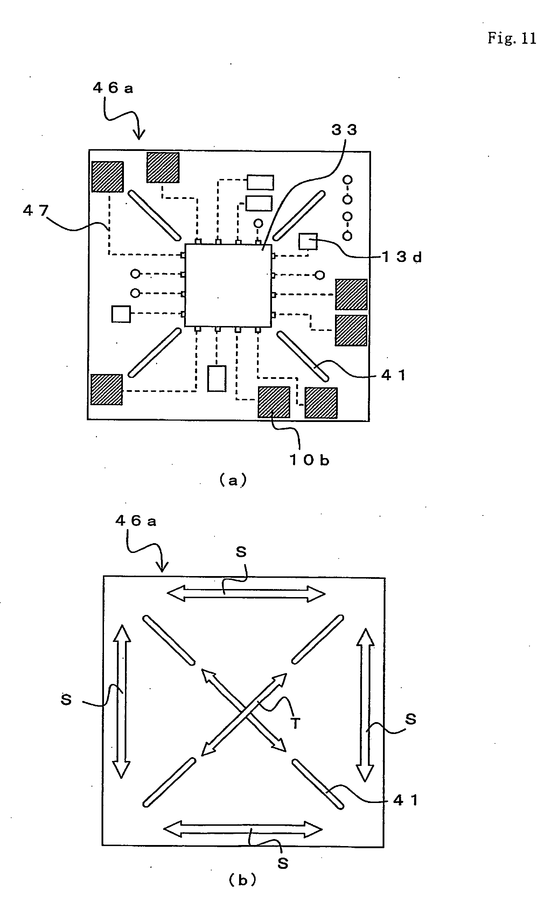

A stress releasing part may be formed at the printed board 46. Fig. 11 illustrates a printed board 46a at which stress releasing parts are formed, particularly, Fig 11 (a) is a top view and Fig. 11 (b) is a back side view.

As illustrated in Fig. 11 (b), there is possibility that the printed board 46a is deformed in the directions between each holding part (the directions of the arrows S and T) when the printed board 46a is installed and then connected to the printed board mounting part 11 as mentioned above. On the printed board 46a, the stress releasing part 41 is formed at a portion other than the areas where a pattern 47, the CPU 33, an electronic component 13d, etc. are formed so as to penetrate a glass epoxy board.

For example, the stress releasing part 41 is a long hole formed in the direction from the four corners of the CPU 33 to the four corners of the board (radiated from the center). The stress releasing part 41 may be a circle, a square, etc. When the printed board 46a is joined with the injection molded board 2, the conductor part 10b of the printed board 46a is fixed to the injection molded board 2. Since the printed board 46a (glass epoxy board) and the injection molded board 2 are configured with different materials, the coefficients of linear expansion differ with each other. In this way, stress is given to the printed board 46a in association with the temperature change.

In this process, when the stress releasing part 41 is formed, it can absorb the deformation of the printed board 46a. For this reason, the breakage of the printed board 46a, the junction fracture of an electrode part, etc. can be prevented.

According to the second embodiment, the similar effect as that of the first embodiment can be acquired. The present embodiment can be applicable to various printed boards such as CPU or others.

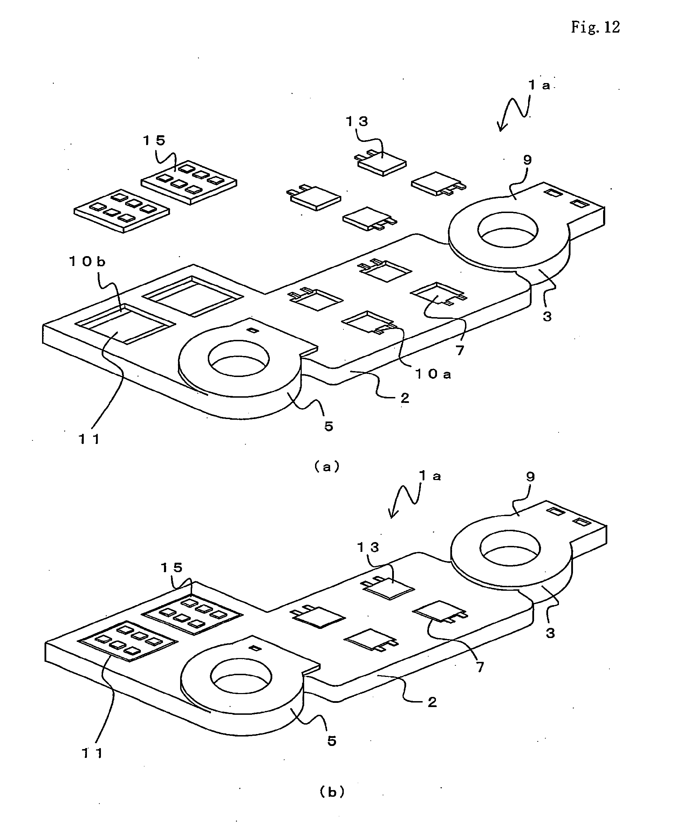

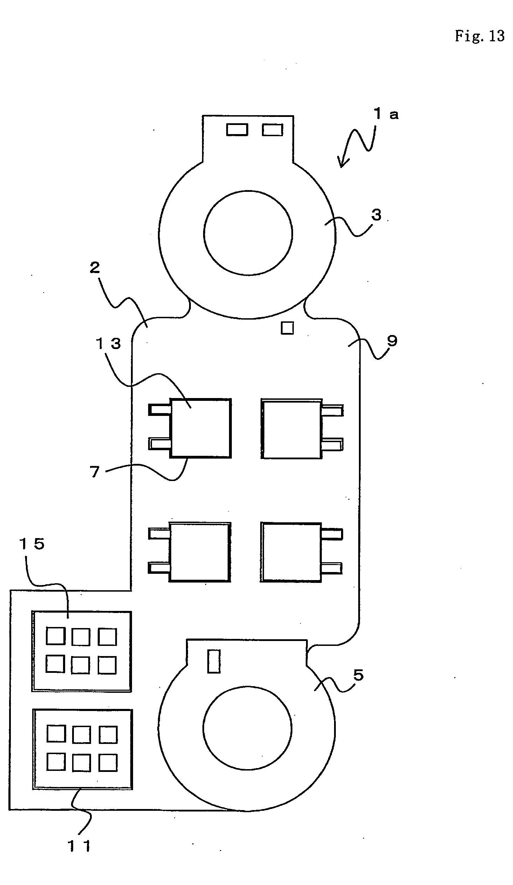

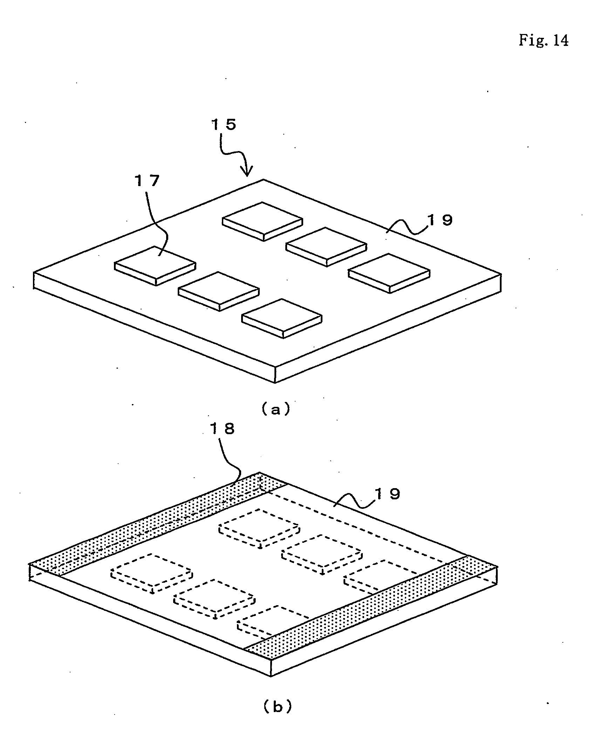

Next, the third embodiments will be described hereinafter. Fig. 12 and Fig. 13 are views of a board 1a, particularly, Fig. 12 (a) is an exploded perspective view, Fig. 12 (b) is an assembly perspective view and Fig. 13 is a top view. Fig. 14 illustrates an example of a printed board 15, particularly, Fig. 14 (a) is a front side perspective view and Fig. 14 (b) is a back side perspective view. Although the board 1a has approximately the same structure as that of the board 1, there is difference in connecting structure of the printed boards between them.

A printed board 15 comprises a glass epoxy board 19 installing thereon ceramic condensers 17 that are a plurality of small electronic components. The ceramic condensers 17 as the third electronic components are electrically connected to the printed board 15, and electrodes 18 that are circuit conductors are formed respectively near a pair of opposite sides on the back surface of the printed board 15.

Such electrodes 18 are electrically connected to conductor parts 10b that are exposed at a printed board mounting part 11, which functions as a circuit of the board 1 a accordingly. At the board 1 a with such printed board 15, low current for such as a signal uses a circuit on the printed board 15 (small capacitor, etc.), as well as high current for power may use a circuit on the injection molded board. All these circuits can be installed on one board and thus it becomes unnecessary to connect each board by a cable, etc., which enables to manufacture a more compact board at low cost.

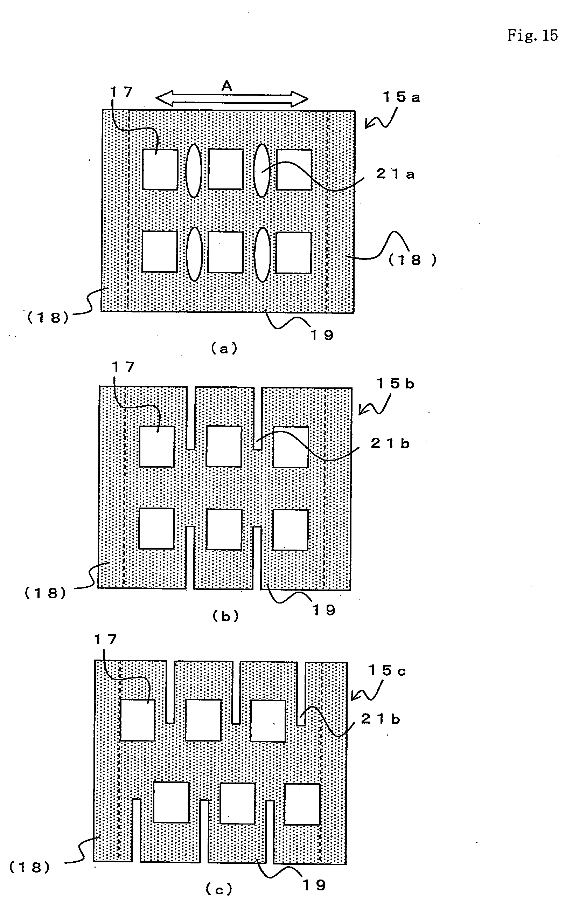

Fig. 15 illustrates modifications of the printed board 15. The printed board 15a illustrated in Fig. 15 (a), includes stress releasing parts 21 a that are formed at the above-mentioned printed board 15. Electrodes 18 are formed at a pair of opposite sides of the back surface of the printed board 15a, and each of the electrodes 18 are joined by solder, etc. to the conductor parts 10b of the injection molded board 10b.

A plurality of ceramic condensers 17 are provided on the front side of the printed board 15a. Stress releasing parts 21 a that are penetration holes penetrating the glass epoxy board 19 are formed between each ceramic condenser 17. The stress releasing parts 21a are formed, in the direction as if extending toward the approximately perpendicular direction to the direction across the pair of the electrodes 18 (the arrow A in the Drawing), in the various shape such as an ellipse, a rectangle, etc. The stress releasing parts 21 a may be a circle, a square, etc.

When the printed board 15a is joined with the injection molded board 2, the electrodes 18 of printed board 15 are fixed to injection molded board 2. Since the printed board 15 (the glass epoxy board 19) and the injection molded board 2 are configured with different materials, the coefficients of linear expansion differ with each other. In this way, stress is given to the printed board 15a in association with the temperature change. For example, if the relative distance of the direction between both of the fixed electrodes 18 (the direction of the arrowA in the drawing) is changed, compression or tensile stress will be applied to the printed board 15a in this direction.

In this process, when the stress releasing parts 21 a are formed, they can absorb the deformation of the printed board 15a. For this reason, the breakage of the printed board 15a, the junction fracture of an electrode part, etc. can be prevented. Here, the arrangements of the electrodes 18 and the ceramic condensers are not limited to the ones illustrated in the drawings, and the stress releasing parts can be suitably arranged in connection with the arrangements of the electrodes 18 and the ceramic condensers 17.

As illustrated in Fig 15 (b), stress releasing parts 21 b in the shape of slit may be employed on a printed board 15b. The stress releasing part 21 b is not a penetrating hole but a penetrating portion for which is provided to be opened to penetrate to the side part of the glass epoxy board 19. In this case, it is desirable for the extending direction of the slit to be perpendicular to the direction across the pair of electrodes 18 (the arrow A in the drawing).

The stress releasing parts may be arranged in zigzag as illustrated in Fig. 15 (c). A printed board 15c installs a plurality of ceramic condensers 17, and electrodes 18 are formed at a pair of opposite sides of the back surface of the printed board 15c. The stress releasing parts 21 b are formed between each ceramic condenser. In this process, the stress releasing parts 21 b are arranged, in a plurality of rows, in the direction crossing between the electrodes 18 on the both ends. An example in Fig. 15 (c) illustrates the stress releasing parts 21 b that are formed, in two rows (two rows in the direction of the arrow A in the drawing), near the both sides other than the portions where the electrodes are placed. Also, each row has a plurality of the stress releasing parts 21 b (three in the drawing) that is arranged side by side.

The stress releasing parts 21 b in the respective rows are arranged in zigzag with each other, which makes difference in the distances from the electrode 18 on one of the sides to each of the stress releasing parts 21 b. In this way, the mechanical strength of the printed board 15c, which may be decreased when forming the stress releasing part 21 b, can be maintained.

According to the board 1 a of the present embodiment, the similar effect as that of the board 1 can be obtained.

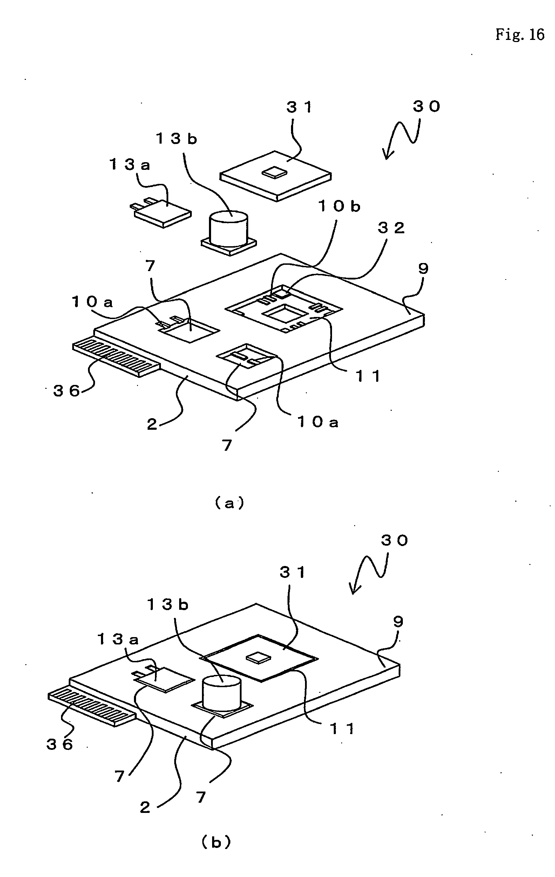

Next, the forth embodiment will be described hereinafter. Fig. 16 is a view of a board 30 according to the forth embodiment, particularly, Fig. 16 (a) is an exploded perspective view, and Fig. 16 (b) is an assembly perspective view.

Although the board 30 has approximately the same structure as that of the board 1a, there is difference in the modes of a printed board 31. The board 30 comprises an electronic component mounting part 7 installing and electrically connecting large-sized electronic components 13a and 13b, such as a diode or an electrolytic condenser. A printed board mounting part 11 installs the printed board 31 thereon.

A conductor part 10b and a holding part 32, which are as conductor exposing parts, are formed at the printed board mounting part 11. The conductor part 10b is a portion for which is provided to be electrically connected to a circuit of the board 30, and for which is provided to be electrically connected by solder, etc. to an electrode of the printed board 31. The holding part 32 is a conductor exposing part (a portion where resin 9 does not cover), and it is used for holding the printed board 31 that will be described later.

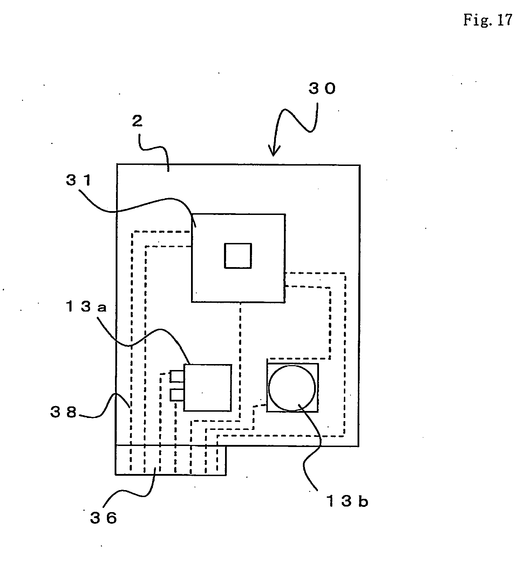

The board 30 is electrically connected by a connector 36 to an external component, power supply, or other material. Fig. 17 is a conceptual view illustrating a pattern formed with a circuit conductor at the inside of the board 30. As illustrated in Fig. 17, at the inside of the board 30, electronic components 13a and 13b, the printed board 31, the connector 36, etc. are electrically connected by the pattern 38

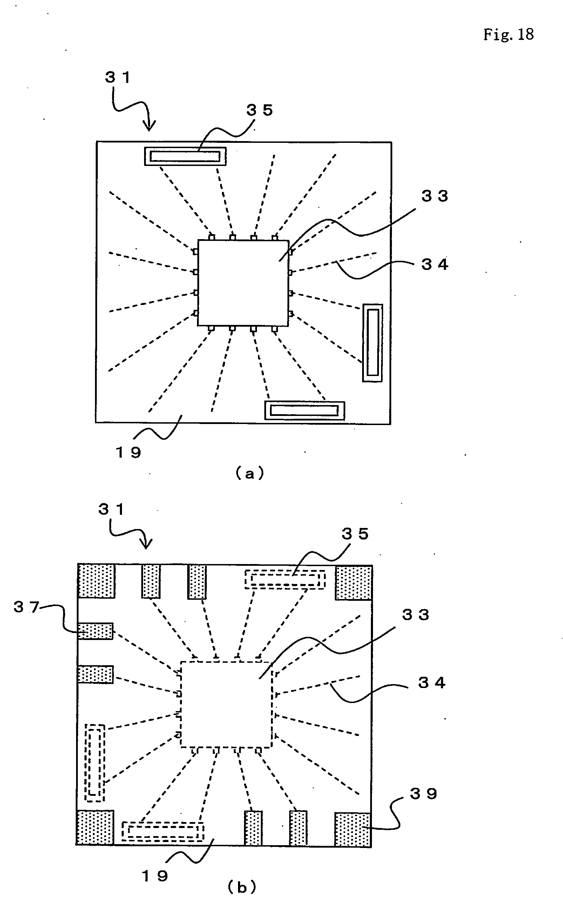

Fig. 18 is a view of the printed board 31, particularly Fig. 18 (a) is a top view and Fig. 18 (b) is a back side view. A CPU 33 that is an electronic component is placed at approximately the center of the printed board 31. At the printed board 31, a pattern 34 that is a circuit connected to the CPU 33 is formed. The CPU 33 is connected by the pattern 34 to a connector 35 for connecting to outside, and it is also connected to a land 37 to be connected to the conductor part 10b of the injection molded board.

Other than the land 37 that is an electrode to be joined to the conductor part 10b of the injection molded board, a board holding part 39 is formed at the back side of the printed board 31. The board holding part 39 is a metal exposing portion, however, it is not necessarily to be connected to the CPU 33, etc. as a circuit. Hence, the board holding part 39 may be a metal exposing part that is merely formed on the surface. The board holding part 39 may be connected to a GND conductor.

The printed board mounting part 11 of the injection molded board 2 installs the printed board 30 thereon, and each of the lands 37 are electrically connected to corresponding conductor parts 10b. In this process, there is possibility that the strength of junction between the printed board 31 and the injection molded board 2 is not sufficient since the land 37 has a small space for junction. In order to hold the printed board 31 on the injection molded board 2 more firmly, the board holding part 39 of the printed board 31 and the holding part 32 of the injection molded board 2 are joined with each other by solder, etc besides electrical connections. Through this process, it is able to increase the strength of junction.

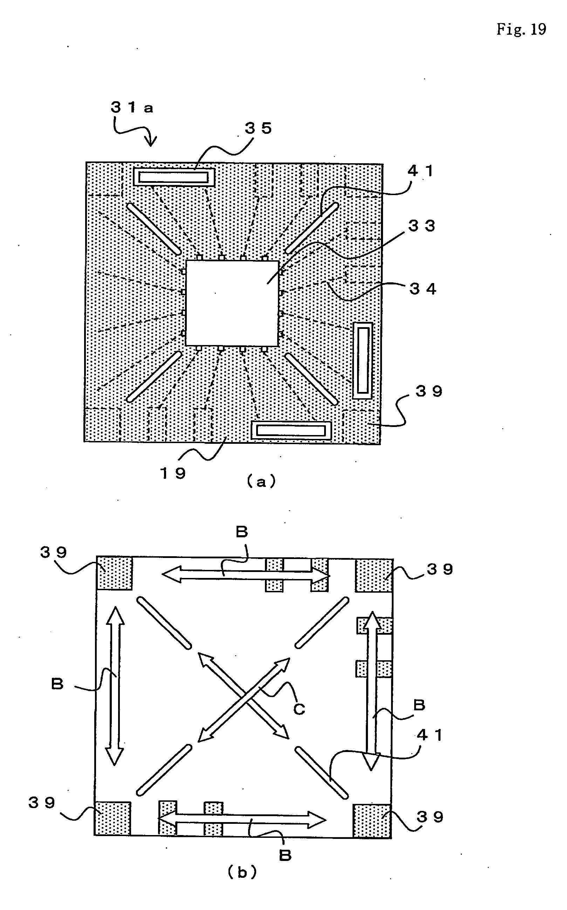

A stress releasing part may be formed at the printed board 31. Fig. 19 is a view of a printed board 31a including a stress releasing part 41 thereon, particularly, Fig. 19 (a) is a top view and Fig. 19 (b) is a back side view.

As illustrated in Fig. 19 (b), there is possibility that the printed board 31 a is deformed in the directions between each holding part (the directions of the arrows B and C) when the printed board 31 a is held with the board holding part 39 as mentioned above. On the printed board 31 a, a stress releasing part 41 is formed at a portion other than the areas where a pattern 34, a CPU 33, a land 37, etc. are arranged so as to penetrate a glass epoxy board 19.

For example, the stress releasing part 41 is a long hole formed in the direction from the four corners of the CPU 33 to the board holding parts 39 that are on the four corners of the board (radiated from the center). In such a configuration with the stress releasing part, deformation amount of the printed board 31 a in each direction can be absorbed as well as the stress can be eased.

According to the forth embodiment, the similar effect as that of the first embodiment can be acquired. The present embodiment can be applicable to various printed boards such as CPU or others.

Although the embodiments of the present invention have been described as the above referring to the drawings attached hereto, the technical scope of the present invention is not limited to the embodiments mentioned above. Apparently, a person skilled in the art is able to achieve other variations or modifications within a category of the technical ideas described in claims according to the present invention, and these variations and modifications will be considered to naturally belong to a technical scope of the present invention.

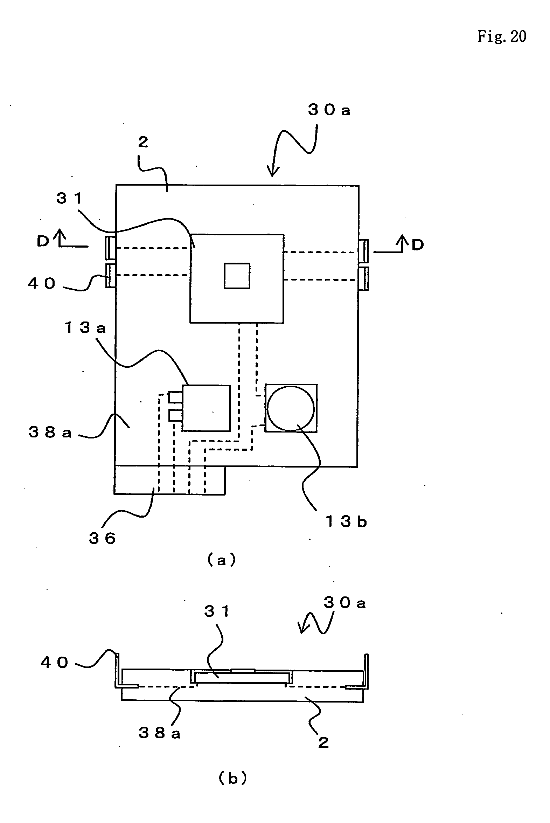

For example and needless to say, each configuration of the stress releasing part, the reinforcing board, etc. at the each of the boards can be combined with each other. Also, it is able to employ the ones other than the connector described above in order to connect the board to outside. Fig. 20 is a view of a board 30a at which a terminal 40 is placed other than the connector, particularly, Fig. 20 (a) is a conceptual view of a pattern 38a and Fig. 20 (b) is a sectional view illustrating the D-D line section in Fig. 20 (a).

The board 30a has approximately the same structure as that of the board 30, however, the board 30a has not only a connector 36, etc. but also has a terminal 40 that is directly exposed from a resin portion of an injection molded board 2 in order to be electrically connected to outside. The terminal 40 is, for example, L-shaped as illustrated, and provided to be one body with a circuit conductor at the inside of the injection molded board or joined by welding with the same to be exposed from the resin portion to outside. Hence, the terminal 40 is connected with a pattern 38a at the circuit conductor. The terminal 40 can be connected by direct welding or soldering to other object to be connected. Accordingly, a connector or a cable becomes unnecessary and thus the number of components can be reduced. The shape of the terminal 40 is not limited to the illustrated one as long as a conductor part is exposed from resin of the board 30a, however, the one which is protruded from the upper, lower and side surfaces of the injection molded board is more desirable given it would be welded with other components.

### REFERENCE SIGNS LIST

- 1, 1a, 30, 40 ......: Board
- 2 ......: Injection molded board
- 3 ......: Transformer
- 5 ......: Choke coil
- 7 ......: Electronic component mounting part
- 9 ......: Resin
- 10a and 10b ......: Conductor part
- 11 ......: Printed board mounting part
- 13, 13a, 13b, 13c ......: Electronic component
- 15 ......: Printed board
- 16 ......: Electronic component
- 17 ......: Ceramic condenser
- 18 ......: Electrode
- 19 ......: Glass epoxy board
- 20 ......: Reinforcing board
- 21a, 21b ......: Stress releasing part
- 22 ......: Circuit conductor
- 23 ......: Solder
- 25 ......: Concave part
- 27 ......: Gap
- 29 ......: Hole
- 31 ......: Printed board
- 32 ......: Holding part
- 33 ......: CPU
- 34 ......: Pattern
- 35 ......: Connector
- 36 ......: Connector
- 37 ......: Land part
- 38 ......: Pattern
- 39 ......: Board holding part
- 41 ......: Stress releasing part
- 42 ......: Positioning pin
- 43 ......: Connector
- 44 ......: Positioning guide
- 46 ......: Printed board
- 47, 48......: Pattern

## Claims

1. A board comprising:
an injection molded board that is molded by injection of resin toward a surface of a circuit conductor;
a first electronic component that is electrically joined on the injection molded board; and
a printed board that installs a second electronic component thereon,
wherein a printed board mounting part that is formed on the injection molded board; and
wherein the printed board is electrically connected to the injection molded board at the printed board mounting part.

2. The board according to claim 1, wherein, in a condition where the printed board is installed on the printed board mounting part, a printed board side conductor part being exposed on a top surface of the printed board and an injection molded board side conductor part being exposed on a top surface of the injection molded board are electrically joined via the first electronic component.

3. The board according to claim 2, wherein a concave part for applying solder is formed on the injection molded board side conductor part.

4. The board according to claim 3, wherein a size of the concave part is not narrower than that of the printed board side conductor part that is to be a subject to connection.

5. The board according to claim 2,
wherein the printed board mounting part installs the printed board, with a gap around the printed board; and
wherein a positioning member that is used to determine a position of the printed board is provided on the printed board mounting part.

6. The board according to claim 2, wherein when the printed board is approximately rectangle and the first electronic components that connect the printed board and the injection molded board are placed on opposite lines of the printed board, each of the first electronic components on opposite lines are placed off alignment with each other.

7. The board according to claim 1, wherein a reinforcing board is provided at inside of the injection molded board so as to stride over the printed board mounting part.

8. The board according to claim 1,
wherein an electronic component mounting part is provided on the injection molded board; and
wherein a third electronic component is electrically joined with the circuit conductor being exposed at the electronic component mounting part, and the circuit conductor being exposed at the printed board mounting part is electrically joined with the printed board.

9. The board according to claim 1, wherein a stress releasing part is formed in the printed board so as to penetrate the printed board.

10. The board according to claim 9,
wherein an electrode part that is to be joined with the circuit conductor exposed at the printed board mounting part is exposed at a back side of the printed board; and
wherein the stress releasing parts are arranged side by side, between each of electronic components to be installed on the printed board and between the electrode parts as well, in a plurality of rows and at a plurality of positions within the respective rows.

11. The board according to claim 9, wherein an electronic component is provided in an approximately center of the printed board and the stress releasing part is radially formed from the electronic component.

12. The board according to claim 8, wherein, other than an electrode part that is electrically connected to the circuit conductor, a holding part that is provided for holding the printed board to the printed board mounting part is formed at a back side of the printed board and the holding part is held by solder to the printed board mounting part.

13. The board according to claim 1, wherein thickness of the circuit conductor of the injection molded board is not less than 400 micrometers and thickness of a conductor in a circuit part of the printed board is not more than 125 micrometers.

14. The board according to claim 1, wherein resin for injection molded board is selected from one of a liquid crystal polymer, poly phenylene sulfide, polybutylene terephthalate, poly ether sulphone, polyether ether ketone, poly phthalamide and the printed board is configured with glass epoxy.

15. A method for manufacturing a board comprising the steps of:
joining circuit materials that are conductors to form a circuit conductor;
injecting molding resin toward a surface of the circuit conductor to mold an injection molded board of which a surface includes an electronic component mounting part and a printer board mounting part; and
connecting electrically an electronic component to the circuit conductor being exposed at the electronic component mounting part and also connecting electrically a printed board that has installed an electronic component beforehand to the circuit conductor being exposed at the printed board mounting part.

16. A method for manufacturing a board comprising the steps of:
joining circuit materials that are conductors to form a circuit conductor;
injecting molding resin toward a surface of the circuit conductor to mold an injection molded board of which a surface has a printed board mounting part;
placing a printed board on the printed board mounting part;
placing solder and a first electronic component respectively on a printed board side conductor part that is exposed on a top surface of the printed board and on an injection molded board side conductor part that is exposed on a top surface of the injection molded board; and
soldering the first electronic component with the printed board side conductor part and the injection molded board side conductor part at one time in a reflow furnace to join the printed board with the injection molded board via the first electronic component.

17. The method for manufacturing a board according to claim 16, wherein a plurality of second electronic components and solder is placed on the printed board to join the second electronic component on the printed board simultaneously with soldering the first electronic component.
